# EUROPEAN PATENT APPLICATION

(11) **EP 4 561 300 A1**
(43) Date of publication of application: **28.05.2025**
(21) Application number: 24210246.5
(22) Date of filing: 31.10.2024
(51) Int. Cl.: H10D 89/60, H10D 8/00

(54) **ELECTROSTATIC DISCHARGE PROTECTION DEVICE**

(30) Priority: 24.11.2023 US 202318518789
(71) Applicant: MediaTek Inc., Hsinchu City, 30078 (TW)
(72) Inventor: LI, Tzung-lin, 30078 Hsinchu City (TW); CHUNG, Yuan-Fu, 30078 Hsinchu City (TW); LEE, Tung-Hsing, 30078 Hsinchu City (TW)
(74) Representative: Haseltine Lake Kempner LLP

(57) **Abstract**

An electrostatic discharge protection device is provided. The electrostatic discharge protection device includes a semiconductor substrate, first and second well regions, and first and second heavily doped regions The first and second well regions have a first conductivity type and are located in the semiconductor substrate. The first heavily doped region on the first well region has a second conductivity type. A first bottom of the first well region and a second bottom of the second well region are connected to each other and have different profiles. The first and second well regions have different doping concentrations. The second heavily doped region on the second well region has the first conductivity type. The first and second heavily doped regions are arranged side-by-side and are spaced apart from each other. The first heavily doped region is electrically connected to an input/output terminal.

## Description

### BACKGROUND OF THE DISCLOSURE

### Field of the Disclosure

The present disclosure relates to an electrostatic discharge protection device, and, in particular, to the structure and layout of an electrostatic discharge protection device for application in high-frequency circuits.

### Description of the Related Art

An electrostatic discharge (ESD) is a phenomenon that releases and transfers charges between a semiconductor device (e.g., a semiconductor chip) and an external object (e.g., a human body). In an ESD, a large amount of charge is released in a short time, and so the energy from an ESD is much higher than the bearing capacity of the semiconductor device, and this may result in a temporary functional failure or even a permanent damage to the semiconductor device. Therefore, an ESD clamp circuit is provided in semiconductor devices to offer an electrostatic discharge path that effectively protects the semiconductor device, so that the reliability and service life of the semiconductor device can be improved. For a high-frequency circuit, however, parasitic capacitors in conventional ESD protection circuits (which use diodes) may suffer from the electrical performance of RF circuits and high-speed circuits.

### BRIEF SUMMARY OF THE DISCLOSURE

An embodiment of the disclosure provides an electrostatic discharge protection device. The electrostatic discharge protection device includes a semiconductor substrate, a first well region, a first heavily doped region, a second well region, and a second heavily doped region. The first well region having a first conductivity type is located in the semiconductor substrate. The first heavily doped region having a second conductivity type is located on the first well region. The second well region having the first conductivity type is located in the semiconductor substrate. A first bottom of the first well region and a second bottom of the second well region are connected to each other and have different profiles. The first well region and the second well region have different doping concentrations. The second heavily doped region has the first conductivity type and is located on the second well region. The first heavily doped region and the second heavily doped region are arranged side-by-side and spaced apart from each other. The first heavily doped region is electrically connected to an input/output terminal.

An embodiment of the disclosure provides a method for forming an electrostatic discharge protection device. The method includes providing a semiconductor substrate. The method further includes performing an implantation process to simultaneously form a first doped region and a second doped region in the semiconductor substrate, wherein the first doped region and the second doped region have a first conductivity type and are adjacent to each other, wherein the first doped region has a first discontinuous portion within. The method further includes performing an annealing process to form a first well region from the first doped region and a second well region from the second doped region, wherein the first well region is formed by diffusing a portion of first dopants in the first doped region into the first discontinuous portion. The method further includes forming a first heavily doped region having a second conductivity type located on the first well region. The method further includes forming a second heavily doped region having the first conductivity type and located on the second well region, wherein the first heavily doped region and the second heavily doped region are arranged side-by-side and spaced apart from each other.

### BRIEF DESCRIPTION OF THE DRAWINGS

The present disclosure can be more fully understood by reading the subsequent detailed description and examples with references made to the accompanying drawings, wherein:
FIG. 1 is a schematic connection diagram of an electrostatic discharge protection device in accordance with some embodiments of the disclosure;
FIG. 2 is a schematic cross-sectional view of the electrostatic discharge protection device of FIG. 1 in accordance with some embodiments of the disclosure;
FIGS. 3 and 4 are schematic cross-sectional views at an intermediate stage of forming an electrostatic discharge protection device in accordance with some embodiments of the disclosure; and
FIGS. 5A, 5B and 5C are plane view of FIG. 3, showing the arrangements of discontinuous portions of a doped region for forming a well region having a lighter doping concentration of an electrostatic discharge protection device in accordance with some embodiments of the disclosure.

### DETAILED DESCRIPTION OF THE DISCLOSURE

The following description is made for the purpose of illustrating the general principles of the disclosure and should not be taken in a limiting sense. The scope of the disclosure is best determined by reference to the appended claims.

Electrostatic discharge (ESD) devices arranged between the input/output (IO) pad and the internal circuit are usually provided to protect the internal circuit. One kind of the current ESD devices is composed of diodes formed by sharing the low voltage P-type well region/N-type well region of the metal-oxide-semiconductor (MOS) device of the internal circuit. In the high-frequency circuit applications, however, the parasitic capacitance of the ESD device may cause increased signal loss, thereby affecting the performance of the internal circuit.

There are two approaches to solve the aforementioned problem. The first one is to use two different masks to separately form the P-type/N-type well region of MOS device and the P-type well/N-type well region of the ESD device in different implantation processes. The P-type well/N-type well region of the ESD device may have a reduced doping concentration, thereby reducing the parasitic capacitance of the diode. The second one is to form the ESD device including two or more diodes connected in series in order to reduce the total capacitance of the parasitic capacitors of the ESD device. However, the first approach results in increased mask cost and manufacturing cost. The second approach results in increased area of the semiconductor device. According to the high-frequency circuit application requirements, it is increasingly becoming necessary to provide an ESD device with a reduced parasitic capacitance and maintain a small device size without adding additional masks.

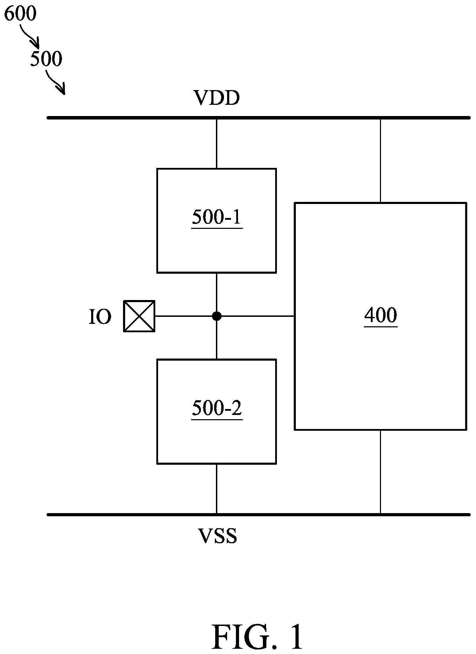

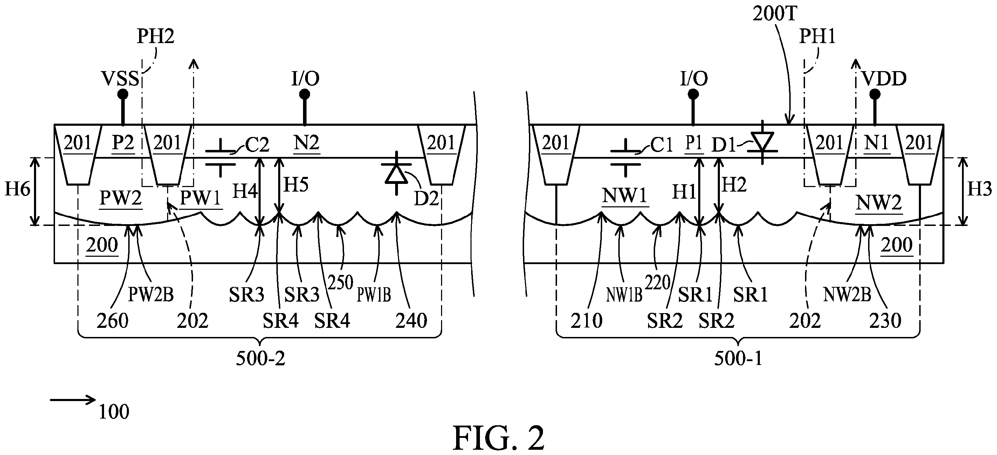

FIG. 1 is a schematic connection diagram of an electrostatic discharge (ESD) protection device 500 disposed in a system 600 in accordance with some embodiments of the disclosure. FIG. 2 is a schematic cross-sectional view of the ESD protection device 500 of FIG. 1 in accordance with some embodiments of the disclosure. The system 600 includes an internal circuit 400 and the electrostatic discharge (ESD) protection device 500 used to protect the internal circuit 400. The internal circuit 400 is electrically connected to an input/output terminal IO, a power supply terminal VDD and a ground terminal VSS of the system 600. In some embodiments, the ESD protection device 500 includes a first ESD protection unit 500-1 and a second ESD protection unit 500-2. The first ESD protection unit 500-1 is electrically connected between the input/output terminal IO and the power supply terminal VDD of the system 600 to prevent an electrostatic discharge current from flowing through the internal circuit 400. The second ESD protection unit 500-2 is electrically connected between the input/output terminal IO and the ground terminal VSS of the system 600 to prevent an electrostatic discharge current from flowing through the internal circuit 400.

As shown in FIG. 2, the ESD protection device 500 includes a semiconductor substrate 200 and the first and second ESD protection units 500-1, 500-2 disposed in the semiconductor substrate 200. In some embodiments, the semiconductor substrate 200 may be P-type semiconductor substrate 200. The first ESD protection unit 500-1 includes a first well region NW1, a first heavily doped region P1, a second well region NW2 and a second heavily doped region N1. The first well region NW1 and the second well region NW2 are located in the semiconductor substrate 200. In some embodiments, the first well region NW1 and the second well region NW2 both have a first conductivity type. For example, when the first conductivity type is N-type, the first and second well regions NW1, NW2 are N-type. In addition, the first and second well regions NW1, NW2 and the semiconductor substrate 200 may have opposite conductivity types. Each of the first and second well regions NW1, NW2 has a heavily doped region formed thereon. For example, the first heavily doped region P1 is located on the first well region NW1. The second heavily doped region N1 is located on the second well region NW2. In some embodiments, the first heavily doped region P1 has a second conductivity type, and the second heavily doped region N1 has the first conductivity type. For example, when the first conductivity type is N-type and the second conductivity type is P-type, the first heavily doped region P1 is a P-type heavily doped region P1, and the second heavily doped region N1 is an N-type heavily doped region N1.

The first well region NW1 and the second well region NW2 are arranged side-by-side along a direction 100 (the direction substantially parallel to a top surface 200T of the semiconductor substrate 200) and are adjacent to each other. In some embodiments, the second heavily doped region N1 and the first heavily doped region P1 are spaced apart from each other by an isolation feature 201 (such as a shallow trench isolation trench isolation (STI)). There may be an interface 202 between the first well region NW1 and the second well region NW2, and the interface 202 may be located below the isolation feature 201. In some embodiments, a first bottom NW1B of the first well region NW1 is connected to and in contact with a second bottom NW2B of the second well region NW2.

In some embodiments, the first bottom NW1B of the first well region NW1 and the second bottom NW2B of the second well region NW2 have different profiles. For example, the first bottom NW1B of the first well region NW1 may have a wave surface. The second bottom NW2B of the second well region NW2 may have an arc surface. The first bottom NW1B of the first well region NW1 may have a wave profile as shown in FIG. 2. The second bottom NW2B of the second well region NW2 may have an arc profile as shown in FIG. 2. In some embodiments, a bottom surface of the first bottom NW1B of the first well region NW1 maybe called a wave bottom surface, and a bottom surface of the second bottom NW2B of the second well region NW2 maybe called an arc bottom surface. In some embodiments, the first well region NW1 has first sub-regions SR1 and second sub-regions SR2 alternately arranged with the first sub-regions SR1. In some embodiments, the number of the first sub-region SR1 is greater than or equal to 2, the number of the first sub-region SR1 is greater than or equal to 2. The first sub-regions SR1 may have a first depth H1. The second sub-regions SR2 may have a second depth H2 that is different from the first depth H1. For example, the first sub-regions SR1 may have convex bottoms, and the second sub-regions SR2 may have concave bottoms. The convex bottoms of the first sub-regions SR1 protrude in a direction away from the top surface 200T (or a top surface of the first well region NW1) of the semiconductor substrate 200. The concave bottoms of the second sub-regions SR2 are recessed in a direction close to the top surface 200T (or the top surface of the first well region NW1) of the semiconductor substrate 200. In addition, the first depth H1 of the first sub-regions SR1 having the convex bottoms may be deeper than the second depth H2 of the second sub-regions SR2 having concave bottoms. In some embodiments, the first depth H1 is measured from the bottommost of the convex bottoms of the first sub-regions SR1 to the top surface of the first well region NW1. In some embodiments, the second depth H2 is measured from the topmost of the concave bottoms of the second sub-regions SR2 to the top surface of the first well region NW1. In some embodiments, as shown in FIG. 2, the wave profile of the first bottom NW1B (or the wave bottom surface of the first well region NW1) includes a plurality of wave crests 210 and a plurality of wave troughs 220, where the wave crests 210 are closer to the top surface of the first well region NW1 (or the top surface 200T of the semiconductor substrate 200) than the wave troughs 220. In some embodiments, the wave troughs 220 are the profile of the bottom of the first sub-regions SR1, and the wave crests 210 are the profile of the bottom of the second sub-regions SR2. In some embodiments, the wave troughs 220 are the bottom surface of the first sub-regions SR1, and the wave crests 210 are the bottom surface of the second sub-regions SR2. The first depth H1 is the distance measured from one of the wave troughs 220 (or the bottommost point of one of the wave troughs 220) to the top surface of the first well region NW1, while the second depth H2 is the distance measured from one of the wave crests 210 (or the topmost point of one of the wave crests 210) to the top surface of first well region NW1. In some embodiments, the number of the wave crests 210 is greater than or equal to 2, and the number of wave troughs 220 is greater than or equal to 2. In some embodiments, the first well region NW1 has at least two points (the bottommost points) of the wave troughs 220, each with the first depth H1; and the second well region NW2 has at least two points (the topmost points) of the wave crests 210, each with the second depth H2. In some embodiments, the number of the wave crests 210 and the number of the wave troughs 220 in FIG. 2 are only for illustration, and the number of wave crests 210 and the number of wave troughs 220 are not limited to the numbers in FIG. 2. In some embodiments, as shown in FIG. 2, the arc profile of the second bottom NW2B (or the arc bottom surface of the second well region NW2) only includes one wave trough 230, and the wave trough 230 protrudes in the direction away from the top surface 200T (or a top surface of the second well region NW2) of the semiconductor substrate 200. In some embodiments, the second bottom NW2B only includes one bottommost point of the wave trough 230, and a third depth H3 measured from the bottommost point to the top surface of the second well region NW2 may be equal to the first depth H1. In one embodiment, the top surface of the first well region NW1 is substantially flush with the top surface of the second well region NW2. As the first well region NW1 and the second well region NW2 are formed in the same process(es), the first depth H1 is equal to the third depth H3. The method of this embodiment can save manufacturing steps and costs (such as photomask costs) and improve manufacturing efficiency and manufacturing accuracy.

In some embodiments, the first well region NW1 having a wavy bottom (the first bottom NW1B) and the second well region NW2 having a rounded (or an arc) bottom (the second bottom NW2B) may have different doping concentrations. For example, the doping concentration of the first well region NW1 may be less than the doping concentration of the second well region NW2.

In some embodiments as shown in FIG. 2, the first well region NW1 and the second well region NW2 may have different number of arc bottoms. For example, the first well region NW1 may have a plurality of arc bottoms. The second well region NW2 may have a single arc bottom. Therefore, the number of the arc bottoms of the first well region NW1 may be greater than the number the arc bottoms of the second well region NW2. In some embodiments, the end of one arc bottom may be connected to the adjacent end of another arc bottom. The arc bottom of the first well region NW1 adjacent to the second well region NW2 is connected to and in contact with the arc bottom of the second well region NW2. In some embodiments, the number of the arc bottoms of the first well region NW1 may be greater than or equal to 2. In some embodiments, the plurality of arc bottoms is connected to each other in turn to form the wave bottom surface of the first well region NW1 (or the wave profile of the first bottom NW1B of the first well region NW1). In some embodiments, the first depth H1 measured from the bottommost point of one of the arc bottoms of the first well region NW1 to a top surface of the first well region NW1 is equal to the third depth H3 measured from the bottommost point of the single arc bottom of the second well region NW2 to a top surface of the second well region NW2. In one embodiment, the top surface of the first well region NW1 is substantially flush with the top surface of the second well region NW2. As the first well region NW1 and the second well region NW2 are formed in the same process(es), the first depth H1 is equal to the third depth H3. The method of this embodiment can save manufacturing steps and costs (such as photomask costs) and improve manufacturing efficiency and manufacturing accuracy.

The first heavily doped region P1 located on the first well region NW1 and the second heavily doped region N1 located on the second well region NW2, the first heavily doped region P1 and the second heavily doped region N1 are arranged along the direction 100 and spaced apart from each other by the isolation feature 201. In this embodiment, the first heavily doped region P1 is electrically connected to the input/output terminal IO, and the second heavily doped region N1 is electrically connected to the power supply terminal VDD.

As shown in FIG. 2, the second ESD protection unit 500-2 includes a third well region PW1, a third heavily doped region N2, a fourth well region PW2 and a fourth heavily doped region P2. The third well region PW1 and the fourth well region PW2 are located in the semiconductor substrate 200 and separated from the first well region NW1 and the second well region NW2 by the isolation feature 201. In some embodiments, the third well region PW1 and the fourth well region PW2 both have the second conductivity type. For example, when the first conductivity type is N-type and the second conductivity type is P-type, the third and fourth well regions PW1, PW2 are P-type well regions. In addition, the third and fourth well regions PW1, PW2 and the semiconductor substrate 200 may have the same conductivity type. Each of the third and fourth well regions PW1, PW2 has a heavily doped region formed thereon. For example, the third heavily doped region N2 is located on the third well region PW1. The fourth heavily doped region P2 is located on the fourth well region PW2. In some embodiments, the third heavily doped region N2 has the first conductivity type, and the fourth heavily doped region P2 has the second conductivity type. For example, when the first conductivity type is N-type and the second conductivity type is P-type, the third heavily doped region N2 is an N-type heavily doped region N2, and the fourth heavily doped region P2 is a P-type heavily doped region P2.

The third well region PW1 and the fourth well region PW2 are arranged side-by-side along a direction 100 (the direction substantially parallel to the top surface 200T of the semiconductor substrate 200) and are adjacent to each other. In some embodiments, the third heavily doped region N2 and the third heavily doped region N2 are spaced apart from each other by the isolation feature 201. There may be an interface 204 between the third well region PW1 and the fourth well region PW2, and the interface 204 may be located below the isolation feature 201. In some embodiments, a third bottom PW1B of the third well region PW1 is connected to and in contact with a fourth bottom PW2B of the fourth well region PW2.

In some embodiments, the third bottom PW1B of the third well region PW1 and the fourth bottom PW2B of the fourth well region PW2 have different profiles. For example, the third bottom PW1B of the third well region PW1 may have a wave surface. The fourth bottom PW2B of the fourth well region PW2 may have an arc (or rounded) surface. The third bottom PW1B of the third well region PW1 may have a wave profile as shown in FIG. 2. The fourth bottom PW2B of the fourth well region PW2 may have an arc profile as shown in FIG. 2. In some embodiments, a bottom surface of the third bottom PW1B of the third well region PW1 maybe called a wave bottom surface, and a bottom surface of the fourth bottom PW2B of the fourth well region PW2 maybe called an arc bottom surface. In some embodiments, the third well region PW1 has third sub-regions SR3 and fourth sub-regions SR4 alternately arranged with the third sub-regions SR3. In some embodiments, the number of the third sub-regions SR3 is greater than or equal to 2, the number of the fourth sub-regions SR4 is greater than or equal to 2. The third sub-regions SR3 may have a fourth depth H4. The fourth sub-regions SR4 may have a fifth depth H5 that is different from the fourth depth H4. For example, the third sub-regions SR3 may have convex bottoms, and the fourth sub-regions SR4 may have concave bottoms. The convex bottoms of the third sub-regions SR3 protrude in a direction away from the top surface 200T (or a top surface of the third well region PW1) of the semiconductor substrate 200. The concave bottoms of the fourth sub-regions SR4 are recessed in a direction close to the top surface 200T (or the top surface of the third well region PW1) of the semiconductor substrate 200. In addition, the fourth depth H4 of the third sub-regions SR3 having the convex bottoms may be deeper than the fifth depth H5 of the fourth sub-regions SR4 having concave bottoms. In some embodiments, the fourth depth H4 is measured from the bottommost of the convex bottoms of the third sub-regions SR3 to the top surface of the third well region PW1. In some embodiments, the fifth depth H5 is measured from the topmost of the concave bottoms of the fourth sub-regions SR4 to the top surface of the third well region PW1. In some embodiments, as shown in FIG. 2, the wave profile of the third bottom PW1B (or the wave bottom surface of the third well region PW1) includes a plurality of wave crests 240 and a plurality of wave troughs 250, where the wave crests 240 are closer to the top surface of the third well region PW1 (or the top surface 200T of the semiconductor substrate 200) than the wave troughs 250. In some embodiments, the wave troughs 250 are the profile of the bottom of the third sub-regions SR3, and the wave crests 240 are the profile of the bottom of the fourth sub-regions SR4. In some embodiments, the wave troughs 250 are the bottom surface of the third sub-regions SR3, and the wave crests 240 are the bottom surface of the fourth sub-regions SR4. The fourth depth H4 is the distance measured from one of the wave troughs 250 (or the bottommost point of one of the wave troughs 250) to the top surface of the third well region PW1, while fifth depth H5 is the distance measured from one of the wave crests 240 (or the topmost point of one of the wave crests 240) to the top surface of the third well region PW1. In some embodiments, the number of the wave crests 240 is greater than or equal to 2, and the number of wave troughs 250 is greater than or equal to 2. In some embodiments, the third well region PW1 has at least two points (the bottommost points) of the wave troughs 250, each with the fourth depth H4; and the fourth well region PW2 has at least two points (the topmost points) of the wave crests 240, each with the fifth depth H5. In some embodiments, the number of the wave crests 240 and the number of the wave troughs 250 in FIG. 2 are only for illustration, and the number of wave crests 240 and the number of wave troughs 250 are not limited to the numbers in FIG. 2. In some embodiments, as shown in FIG. 2, the arc profile of the fourth bottom PW2B (or the arc bottom surface of the fourth well region PW2) only includes one wave trough 260, and the wave trough 260 protrudes in the direction away from the top surface 200T (or a top surface of the fourth well region PW2) of the semiconductor substrate 200. In some embodiments, the fourth bottom PW2B only includes one bottommost point of the wave trough 260, and a sixth depth H6 measured from the bottommost point to the top surface of the fourth well region PW2 may be equal to the fourth depth H4. In one embodiment, the top surface of the third well region PW1 is substantially flush with the top surface of PW2B. As the third well region PW1 and the fourth well region PW2 are formed in the same process(es), the fourth depth H4 is equal to the sixth depth H6. The method of this embodiment can save manufacturing steps and costs (such as photomask costs) and improve manufacturing efficiency and manufacturing accuracy.

In some embodiments, the third well region PW1 having a wavy bottom (the third bottom PW1B) and the fourth well region PW2 having a rounded (or an arc) bottom (the fourth bottom PW2B) may have different doping concentrations. For example, the doping concentration of the third well region PW1 may be less than the doping concentration of the fourth well region PW2.

In some embodiments as shown in FIG. 2, the third well region PW1 and the fourth well region PW2 may have different number of arc bottoms. For example, the third well region PW1 may have a plurality of arc bottoms. The fourth well region PW2 may have a single arc bottom. Therefore, the number of the arc bottoms of the third well region PW1 may be greater than the number the arc bottoms of the fourth well region PW2. In some embodiments, the end of one arc bottom may be connected to the adjacent end of another arc bottom. The arc bottom of the third well region PW1 adjacent to the fourth well region PW2 is connected to and in contact with the arc bottom of the fourth well region PW2. In some embodiments, the number of the arc bottoms of the third well region PW1 may be greater than or equal to 2. In some embodiments, the plurality of arc bottoms is connected to each other in turn to form wave bottom surface of the third well region PW1 (or the wave profile of the third bottom PW1B of the third well region PW1). In some embodiments, the fourth depth H4 measured from the bottommost point of one of the arc bottoms of the third well region PW1 to a top surface of the third well region PW1 is equal to the sixth depth H6 measured from the bottommost point of the single arc bottom of the fourth well region PW2 to a top surface of the fourth well region PW2. In one embodiment, the top surface of the third well region PW1 is substantially flush with the top surface of the fourth well region PW2. As the third well region PW1 and the fourth well region PW2 are formed in the same process(es), the fourth depth H4 is equal to the sixth depth H6. The method of this embodiment can save manufacturing steps and costs (such as photomask costs) and improve manufacturing efficiency and manufacturing accuracy.

The third heavily doped region N2 located on the third well region PW1 and the fourth heavily doped region P2 located on the fourth well region PW2, the third heavily doped region N2 and the fourth heavily doped region P2 are arranged along the direction 100 and spaced apart from each other by an isolation feature 201. In this embodiment, the third heavily doped region N2 is electrically connected to the input/output terminal IO, and the fourth well region PW2 is electrically connected to the ground terminal VSS.

FIG. 2 also shows an equivalent discharge circuit diagram of the ESD protection device 500 when an electrostatic discharge (ESD) event occurs between the input/output terminal IO and the power supply terminal VDD or between the ground terminal VSS and the input/output terminal IO. Furthermore, FIG. 2 shows parasitic elements of an equivalent discharge circuit at the corresponding positions of the first and second ESD protection units 500-1, 500-2 of the ESD protection device 500. As shown in FIG. 2, the first well region NW1 and second well region NW2 and the first heavily doped region P1 of the first ESD protection unit 500-1 form a first parasitic diode D1. When an electrostatic discharge event occurs between the input/output terminal IO and the power supply terminal VDD, the first parasitic diode D1 is triggered to ON (turned-on) to form a current path PH1 from the input/output terminal IO to the power supply terminal VDD to discharge the electrostatic charges away from the internal circuit 400.

As shown in FIG. 2, the third well region PW1 and the fourth well region PW2 and the third heavily doped region N2 of the second ESD protection unit 500-2 form a second parasitic diode D2. When an electrostatic discharge event occurs between the ground terminal VSS and the input/output terminal IO, the second parasitic diode D2 is triggered to ON to form a current path PH2 from the ground terminal VSS to the input/output terminal IO to discharge the electrostatic charges away from the internal circuit 400.

When the internal circuits 400 is in normal operation (no electrostatic discharge event occurs), the PN junction formed by the first well region NW1 and the first heavily doped region P1 of the first ESD protection unit 500-1 may be in reverse bias condition and form a first parasitic capacitor C1. In addition, the PN junction formed by the third well region PW1 and the third heavily doped region N2 of the ESD second protection unit 500-2 may be in reverse bias condition and form a second parasitic capacitor C2. In some embodiments, the doping concentration the first well region NW1 is turned to be lower than that of the second well region NW2. The doping concentration the third well region PW1 is turned to be lower than that of the fourth well region PW2. Therefore, the first parasitic capacitor C1 and the second parasitic capacitor C2 may have lower parasitic capacitances (i.e., the depletion capacitances). Therefore, the electrostatic discharge (ESD) protection device 500 may have a reduced signal loss in high-speed application.

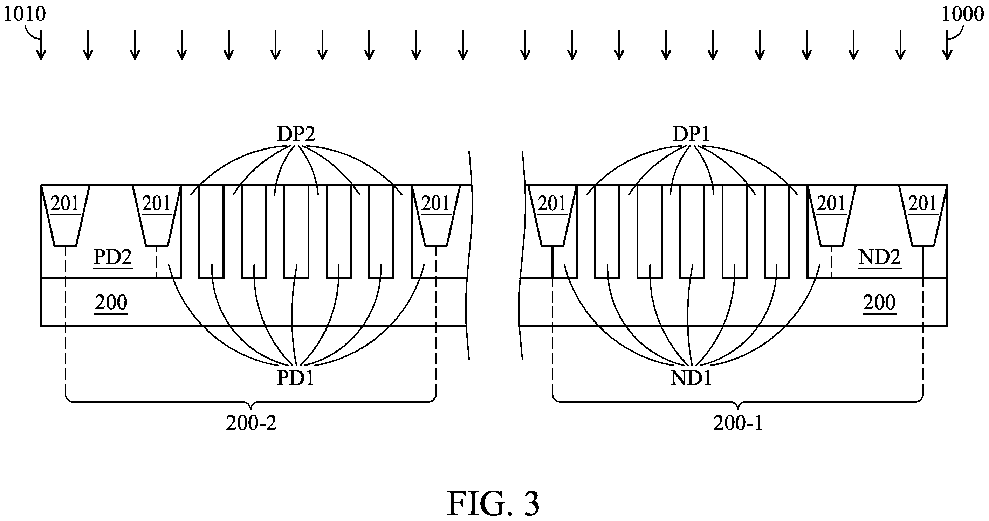

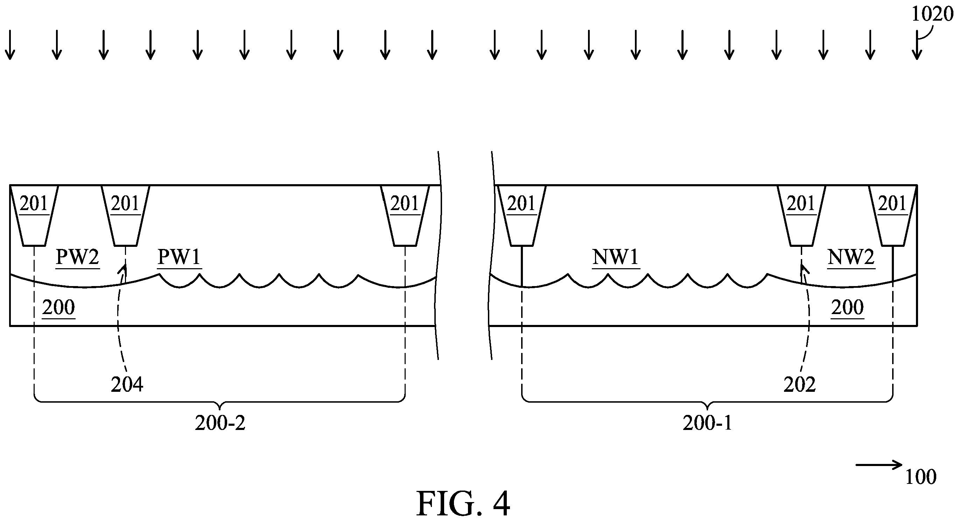

A method for forming the ESD protection device 500 is described below. FIGS. 3 and 4 are schematic cross-sectional views at an intermediate stage of forming the ESD protection device 500 in accordance with some embodiments of the disclosure. Referring to FIG. 3, the semiconductor substrate 200 is provided. The semiconductor substrate 200 has a first device region 200-1 and a second device region 200-2 separated from the first device region 200-1 by the isolation feature 201. The first device region 200-1 may provide the first ESD protection unit 500-1 formed therein, and the second device region 200-2 may provide the second ESD protection unit 500-2 formed therein. Next, an implantation process 1000 is performed to simultaneously form a first doped region ND1 and a second doped region ND2 in the semiconductor substrate 200, and the first doped region ND1 and the second doped region ND2 are adjacent to each other. The first doped region ND1 may be connected to the second doped region ND2. In some embodiments, the first doped region ND1 has at least one discontinuous portion DP1 within. The second doped region ND2 may be formed without discontinuous portions within. In some embodiments, the second doped region ND2 is a continuous doped region, and there are no other portions within the second doped region ND2 that have a different type or composition of the second doped region ND2. In addition, an implantation process 1010 is performed to simultaneously form a third doped region PD1 and a fourth doped region PD2 in the semiconductor substrate 200, and the third doped region PD1 and the fourth doped region PD2 are adjacent to each other. The third doped region PD1 may be connected to the fourth doped region PD2. In some embodiments, the third doped region PD1 has at least one discontinuous portion DP2 within. The fourth doped region PD2 may be formed without discontinuous portions within. In some embodiments, the fourth doped region PD2 is a continuous doped region, and there are no other portions within the fourth doped region PD2 that have a different type or composition of the fourth doped region PD2. In some embodiments, the implantation process 1000 and the implantation process 1010 are different ion implantation processes and implanted with dopants of different conductivity types. For example, the first doped region ND1 and the second doped region ND2 may have the first conductivity type by implanting an N-type dopant, which may include phosphorus, arsenic, nitrogen, antimony, or a combination thereof. For example, the third doped region PD1 and the fourth doped region PD2 may have the second conductivity type (i.e., P-type) by implanting a P-type dopant, which may include boron, gallium, aluminum, indium, boron trifluoride ions (BF₃⁺), or a combination thereof.

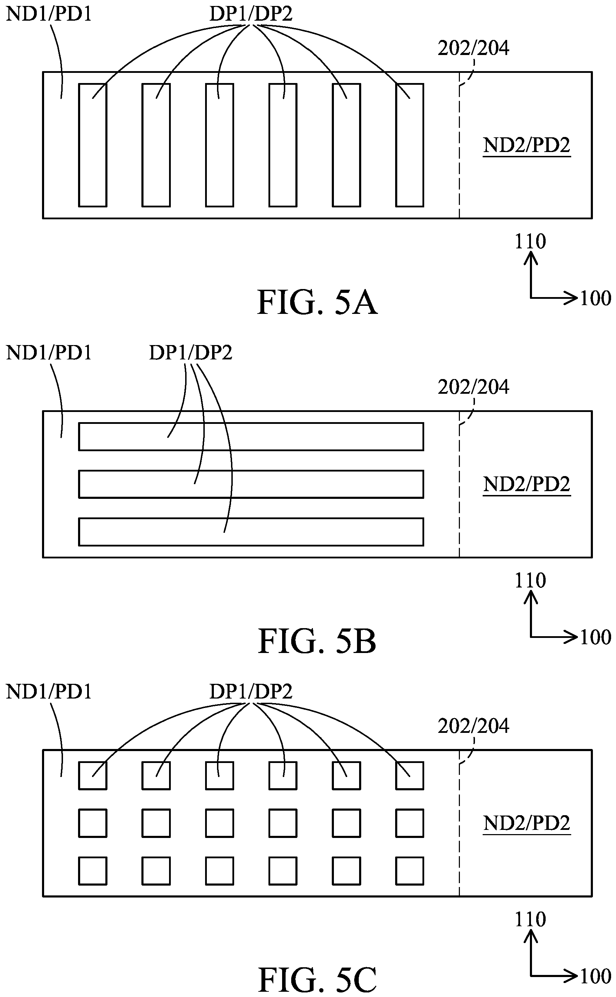

FIGS. 5A, 5B and 5C are plane views of FIG. 3, showing the arrangements of the discontinuous portions DP1 of the first doped region ND1 (or the discontinuous portions DP2 of the third doped region PD1) for forming the first well region NW1 (or the third well region PW1) and the adjacent second doped region ND2 for forming second well region NW2 (or the fourth doped region PD2 for forming the fourth well region PW2) of the ESD protection device 500 in accordance with some embodiments of the disclosure. For illustration, the isolation features 201 are hidden. In addition, the orientation of the first well region NW1 (or the third well region PW1) and the adjacent second well region NW2 (or the fourth well region PW2) shown in FIG. 3 is merely an example and not limited to the disclosed embodiments. In some embodiments, the first doped region ND1 (or the third doped region PD1) surrounds the discontinuous portion DP1 (or the discontinuous portions DP2). In some embodiments, the discontinuous portions DP1 (or the discontinuous portions DP2) may be separated from each other and have various shapes in the top view. As shown in FIG. 5A, the first doped region ND1 (or the third doped region PD1) may have strip-shaped discontinuous portions DP1 (or the discontinuous portions DP2) arranged along the direction 100, and the strip-shaped discontinuous portions DP1 (or the discontinuous portions DP2) extending along a direction 110 that is different from the direction 100. As shown in FIG. 5B, the first doped region ND1 (or the third doped region PD1)) may have strip-shaped discontinuous portions DP1 (or the discontinuous portions DP2) arranged along the direction 110 and extending along the direction 100. As shown in FIG. 5C, the first doped region ND1 (or the third doped region PD1)) may have square-shaped discontinuous portions DP1 (or the discontinuous portions DP2) arranged along the direction 110 and the direction 100. In some embodiments, the discontinuous portions DP1 (or the discontinuous portions DP2) may be circular, oval, or polygonal. It should be noted that the shape of the first doped region ND1 (or the third doped region PD1) not limited to the disclosed embodiments.

Next, referring to FIG. 4, an annealing process 1020 is performed to form the first well region NW1 from the first doped region ND1 (FIG. 3), a second well region NW2 from the second doped region ND2 (FIG. 3), the third well region PW1 from the third doped region PD1 (FIG. 3) and the fourth well region PW2 from the fourth doped region PD2 (FIG. 3). In some embodiments, the first well region NW1 is formed by diffusing a portion of dopants (e.g., N-type dopants) in the first doped region ND1 into the discontinuous portion DP1 (FIG. 3). In addition, the third well region PW1 is formed by diffusing a portion of dopants (e.g., P-type dopants) in the third doped region PD1 into the discontinuous portion DP2 (FIG. 3). Therefore, the first well region NW1 and the adjacent second well region NW2 may have different bottom profiles and doping concentrations. For example, the first well region NW1 may have the wavy bottom (the first bottom NW1B) and the second well region NW2 may have the arc (or rounded) bottom (the second bottom NW2B). The doping concentration of the first well region NW1 may be less than the doping concentration of the second well region NW2. In addition, the third well region PW1 and the adjacent fourth well region PW2 may have different bottom profiles and doping concentrations. For example, the third well region PW1 may have the wavy bottom (the first bottom PW1B) and the fourth well region PW2 may have the arc (or rounded) bottom (the second bottom PW2B). The doping concentration of the third well region PW1 may be less than the doping concentration of the fourth well region PW2. In some embodiments, as the first well region NW1 and the second well region NW2 (or the third well region PW1 and the fourth well region PW2) having different doping concentrations are simultaneously formed without additional masks and process steps, the method of this embodiment can save manufacturing steps and costs (such as photomask costs) and improve manufacturing efficiency and manufacturing accuracy.

Next, as shown in FIG. 2, multiple ion implantation processes may be performed to form the first heavily doped region P1, the second heavily doped region N1, the third heavily doped region N2 and the fourth heavily doped region P2. The first heavily doped region P1 having the second conductivity type (e.g., P-type) located on the first well region NW1. The second heavily doped region N1 having the first conductivity type (e.g., N-type) and located on the second well region NW2. In some embodiments, the first heavily doped region P1 and the second heavily doped region N1 are arranged side-by-side and spaced apart from each other by the isolation feature 201. The third heavily doped region N2 having the first conductivity type (e.g., N-type) located on the third well region PW1. The fourth heavily doped region P2 having the second conductivity type (e.g., P-type) and located on the fourth well region PW2. In some embodiments, the third heavily doped region N2 and the fourth heavily doped region P2 are arranged side-by-side and spaced apart from each other by the isolation feature 201. After the aforementioned processes, the ESD device 500 including the first and second ESD protection units 500-1 and 500-2 is formed.

Embodiments provide an electrostatic discharge (ESD) protection device and method for forming the same. The ESD protection device can discharge the electrostatic charges away from the internal circuits when the electrostatic discharge events occurs between the terminals of the input/output terminal IO and the power supply terminal VDD, or between the terminals of the ground terminal VSS and the input/output terminal IO. The ESD protection device includes a semiconductor substrate, adjacent first and second well regions of a first conductivity type in the semiconductor substrate, a first heavily doped region of a second conductivity type on the first well region and a second heavily doped region of the first conductivity type and located on the second well region. In some embodiments, the first well region and the second well region having different doping concentrations are simultaneously formed without additional masks and process steps. The first well region may be formed by annealing a first doped region at least one first discontinuous portion within. A portion of first dopants in the first doped region may be diffused into the first discontinuous portion, thereby forming the first well region. In addition, the second well region may be formed by annealing a second doped region without discontinuous portions within. Therefore, the first and second well region may have different profiles. For example, the first bottom of the first well region may have a wave profile, and the second bottom of the second well region may have an arc profile in a cross-sectional view. In some embodiments, the doping concentration of the first well region is less than that of the second well region.

When the electrostatic discharge (ESD) event occurs between the input/output terminal IO and the power supply terminal VDD, the parasitic diode (the first parasitic diode D1) formed of the first heavily doped region and the first well region is triggered to ON (turned-on) to form the current path from the input/output terminal IO to the power supply terminal VDD to discharge the electrostatic charges away from the internal circuit. When an electrostatic discharge event occurs between the ground terminal VSS and the input/output terminal IO, the parasitic diode (the second parasitic diode D2) formed of the third heavily doped region and the third well region is triggered to ON to form the current path from the ground terminal VSS to the input/output terminal IO to discharge the electrostatic charges away from the internal circuit.

When the internal circuits are in normal operation (no electrostatic discharge event occurs), the depletion capacitances of the parasitic capacitor (the first parasitic capacitor C1) formed at the reverse-biased PN junction between the first well region NW1 and the first doped region P1 and the parasitic capacitor (the second parasitic capacitor C2) formed at the reverse-biased PN junction between the third well region PW1 and the third heavily doped region N2 may have reduced parasitic capacitances (i.e., the depletion capacitances). Therefore, the electrostatic discharge (ESD) protection device may have a reduced signal loss in high-speed application and maintain a small device size without adding additional masks.

While the disclosure has been described by way of example and in terms of the preferred embodiments, it should be understood that the disclosure is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

The present invention may also be defined by the following numbered clauses.
1. An electrostatic discharge protection device, comprising:
   a semiconductor substrate;
   a first well region having a first conductivity type located in the semiconductor substrate; and
   a second well region having the first conductivity type located in the semiconductor substrate and adjacent to the first well region, wherein a first bottom of the first well region and a second bottom of the second well region are connected to each other and have different profiles, and wherein the first well region and the second well region have different doping concentrations.
2. The electrostatic discharge protection device of clause 1, wherein a first doping concentration of the first well region is less than a second doping concentration of the second well region.
3. The electrostatic discharge protection device of clause 1, wherein the first bottom of the first well region has a wave bottom surface and the second bottom of the second well region has an arc bottom surface.
4. The electrostatic discharge protection device of clause 3, wherein the wave bottom surface of the first well region includes a plurality of wave crests and a plurality of wave troughs, wherein the wave crests are closer to a top surface of the semiconductor substrate than the wave troughs.
5. The electrostatic discharge protection device of clause 4, wherein the first well region has first sub-regions and second sub-regions alternately arranged with the first sub-regions, wherein the wave troughs are the bottom surface of the first sub-regions, and the wave crests are the bottom surface of the second sub-regions.
6. The electrostatic discharge protection device of clause 5, wherein the first sub-regions have a first depth, and the second sub-regions have a second depth that is different from the first depth.
7. The electrostatic discharge protection device of clause 6, wherein the first depth is measured from the bottommost point of one of the wave troughs to a top surface of the first well region, and the second depth is measured from the topmost point of one of the wave crests to the top surface of the first well region.
8. The electrostatic discharge protection device of clause 6, wherein the arc bottom surface of the second well region only includes one wave trough that protrudes in a direction away from the top surface of the semiconductor substrate.
9. The electrostatic discharge protection device of clause 8, wherein a third depth measured from the bottommost point of the wave trough of the second well region to a top surface of the second well region is equal to the first depth.
10. The electrostatic discharge protection device of clause 1, further comprising:
   a third well region having the second conductivity type located in the semiconductor substrate and separated from the first well region and the second well region; and
   a fourth well region having the second conductivity type located in the semiconductor substrate and separated from the first well region and the second well region, wherein a third bottom of the third well region is connected to a fourth bottom of the fourth well region, and wherein the third bottom of the third well region and the fourth bottom of the fourth well region have different profiles and different doping concentrations.
11. The electrostatic discharge protection device of clause 10, wherein a third bottom of the third well region has a wave bottom surface and the fourth bottom of the fourth well region has an arc bottom surface.
12. The electrostatic discharge protection device of clause 11, wherein the wave bottom surface of the third well region includes a plurality of wave crests and a plurality of wave troughs, wherein the wave crests are closer to a top surface of the semiconductor substrate than the wave troughs, and wherein the arc bottom surface of the fourth well region only includes one wave trough that protrudes in a direction away from the top surface of the semiconductor substrate.
13. The electrostatic discharge protection device of clause 12, wherein a fourth depth measured from the bottommost point of one of the wave troughs of the third well region to a top surface of the third well region is equal to a fifth depth measured from the bottommost point of the one wave trough of the fourth well region to a top surface of the fourth well region.
14. An electrostatic discharge protection device, comprising:
   a semiconductor substrate;
   a first well region having a first conductivity type located in the semiconductor substrate; and
   a second well region having the first conductivity type located in the semiconductor substrate and adjacent to the first well region, wherein a first number of first arc bottoms of the first well region is different from a second number of second arc bottoms of the second well region, and wherein the first well region and the second well region have different doping concentrations.
15. The electrostatic discharge protection device of clause 14, wherein the first number of the first arc bottoms of the first well region is greater than or equal to 2, and the second number of second arc bottoms of the second well region is equal to 1.
16. The electrostatic discharge protection device of clause 15, wherein the first arc bottoms are connected to each other in turn to form a wave bottom surface of the first well region.
17. The electrostatic discharge protection device of clause 16, wherein a first depth measured from the bottommost point of one of the first arc bottoms of the first well region to a top surface of the first well region is equal to a second depth measured from the bottommost point of the second arc bottom of the second well region to a top surface of the second well region.
18. A method for forming an electrostatic discharge protection device, comprising:
   providing a semiconductor substrate;
   performing an implantation process to simultaneously form a first doped region and a second doped region in the semiconductor substrate, wherein the first doped region and the second doped region have a first conductivity type and are adjacent to each other, wherein the first doped region has a first discontinuous portion within; and
   performing an annealing process to form a first well region from the first doped region and a second well region from the second doped region, wherein the first well region and the second well region have different doping concentrations
19. The method for forming an electrostatic discharge protection device of clause 18, wherein the first well region is formed by diffusing a portion of first dopants in the first doped region into the first discontinuous portion.
20. The method for forming an electrostatic discharge protection device of clause 18, wherein the second doped region is formed without discontinuous portions within.

## Claims

1. An electrostatic discharge protection device (500), comprising:
a semiconductor substrate (200);
a first well region (NW1) having a first conductivity type located in the semiconductor substrate (200); and
a second well region (NW2) having the first conductivity type located in the semiconductor substrate (200) and adjacent to the first well region (NW1), wherein a first bottom (NW1B) of the first well region (NW1) and a second bottom (NW2B) of the second well region (NW2) are connected to each other and have different profiles, and wherein the first well region (NW1) and the second well region (NW2) have different doping concentrations.

2. The electrostatic discharge protection device (500) as claimed in claim 1, wherein a first doping concentration of the first well region (NW1) is less than a second doping concentration of the second well region (NW2).

3. The electrostatic discharge protection device (500) as claimed in claim 1, wherein the first bottom (NW1B) of the first well region (NW1) has a wave bottom surface and the second bottom (NW2B) of the second well region (NW2) has an arc bottom surface.

4. The electrostatic discharge protection device (500) as claimed in claim 3, wherein the wave bottom surface of the first well region (NW1) includes a plurality of wave crests (210, 240) and a plurality of wave troughs (220, 230, 250, 260), wherein the wave crests (210, 240) are closer to a top surface (200T) of the semiconductor substrate (200) than the wave troughs (220, 230, 250, 260).

5. The electrostatic discharge protection device (500) as claimed in claim 4, wherein the first well region (NW1) has first sub-regions and second sub-regions (SR2) alternately arranged with the first sub-regions (SR1), wherein the wave troughs (220, 230, 250, 260) are the bottom surface of the first sub-regions (SR1), and the wave crests (210, 240) are the bottom surface of the second sub-regions (SR2).

6. The electrostatic discharge protection device (500) as claimed in claim 5, wherein the first sub-regions (SR1) have a first depth (H1), and the second sub-regions (SR2) have a second depth (H2) that is different from the first depth (H1).

7. The electrostatic discharge protection device (500) as claimed in claim 6, wherein the first depth (H1) is measured from the bottommost point of one of the wave troughs (220, 230, 250, 260) to a top surface (200T) of the first well region (NW1), and the second depth (H2) is measured from the topmost point of one of the wave crests (210, 240) to the top surface (200T) of the first well region (NW1).

8. The electrostatic discharge protection device (500) as claimed in claim 6, wherein the arc bottom surface of the second well region (NW2) only includes one wave trough (220, 230, 250, 260) that protrudes in a direction (100, 110) away from the top surface (200T) of the semiconductor substrate (200),
optionally wherein a third depth (H3) measured from the bottommost point of the wave trough (220, 230, 250, 260) of the second well region (NW2) to a top surface (200) of the second well region (NW2) is equal to the first depth (H1).

9. The electrostatic discharge protection device (500) as claimed in claim 1, further comprising:
a third well region (PW1) having the second conductivity type located in the semiconductor substrate (200) and separated from the first well region (NW1) and the second well region (NW2); and
a fourth well region (PW2) having the second conductivity type located in the semiconductor substrate (200) and separated from the first well region (NW1) and the second well region (NW2), wherein a third bottom (PW1B)
of the third well (PW1) region is connected to a fourth bottom (PW2B) of the fourth well region (PW2), and wherein the third bottom (PW1B) of the third well region (PW1) and the fourth bottom (PW2B) of the fourth well region (PW2) have different profiles and different doping concentrations.

10. The electrostatic discharge protection device (500) as claimed in claim 9, wherein a third bottom (PW1B) of the third well region (PW1) has a wave bottom surface and the fourth bottom (PW2B) of the fourth well region (PW2) has an arc bottom surface.

11. The electrostatic discharge protection device (500) as claimed in claim 10, wherein the wave bottom surface of the third well region (PW1) includes a plurality of wave crests (210, 240) and a plurality of wave troughs (220, 230, 250, 260), wherein the wave crests (210, 240) are closer to a top surface (200T) of the semiconductor substrate (200) than the wave troughs (220, 230, 250, 260), and wherein the arc bottom surface of the fourth well region (PW2) only includes one wave trough (220, 230, 250, 260) that protrudes in a direction (100, 110) away from the top surface (200T) of the semiconductor substrate (200),
optionally wherein a fourth depth measured from the bottommost point of one of the wave troughs (220, 230, 250, 260) of the third well region (PW1) to a top surface (200T) of the third well region (PW1) is equal to a fifth depth measured from the bottommost point of the one wave trough (220, 230, 250, 260) of the fourth well region (PW2) to a top surface (200T) of the fourth well region (PW2).

12. An electrostatic discharge protection device (500), comprising:
a semiconductor substrate (200);
a first well region (NW1) having a first conductivity type located in the semiconductor substrate (200); and
a second well region (NW2) having the first conductivity type located in the semiconductor substrate (200) and adjacent to the first well region (NW1), wherein a first number of first arc bottoms of the first well region (NW1) is different from a second number of second arc bottoms of the second well region (NW2), and wherein the first well region (NW1) and the second well region (NW2) have different doping concentrations.

13. The electrostatic discharge protection device (500) as claimed in claim 12, wherein the first number of the first arc bottoms of the first well region (NW1) is greater than or equal to 2, and the second number of second arc bottoms of the second well region (NW2) is equal to 1,
optionally wherein the first arc bottoms are connected to each other in turn to form a wave bottom surface of the first well region (NW1),
optionally wherein a first depth (H1) measured from the bottommost point of one of the first arc bottoms of the first well region (NW1) to a top surface (200T) of the first well region (NW1) is equal to a second depth (H2) measured from the bottommost point of the second arc bottom of the second well region (NW2) to a top surface (200T) of the second well region (NW2).

14. A method for forming an electrostatic discharge protection device (500), comprising:
providing a semiconductor substrate (200);
performing an implantation process (1000, 1010) to simultaneously form a first doped region (ND1) and a second doped region (ND2) in the semiconductor substrate (200), wherein the first doped region (ND1) and the second doped region (ND2) have a first conductivity type and are adjacent to each other, wherein the first doped region (ND1) has a first discontinuous portion (DP1) within; and
performing an annealing process (1020) to form a first well region (NW1) from the first doped region (ND1) and a second well region (NW2) from the second doped region (ND2), wherein the first well region (NW1) and the second well region (NW2) have different doping concentrations.

15. The method for forming an electrostatic discharge protection device (500) as claimed in claim 14, wherein the first well region (NW1) is formed by diffusing a portion of first dopants in the first doped region (ND1) into the first discontinuous portion (DP1); and/or
wherein the second doped region (ND2) is formed without discontinuous portions within.
